# EUROPEAN PATENT APPLICATION

(11) **EP 3 038 126 A1**
(43) Date of publication of application: **29.06.2016**
(21) Application number: 14307128.0
(22) Date of filing: 22.12.2014
(51) Int. Cl.: H01H 59/00

(54) **MEMS structure with thick movable membrane**

(71) Applicant: DelfMEMS SAS, 59650 Villeneuve d'Ascq (FR)
(72) Inventor: Rollier, Anne-Sophie, 59000 Lille (FR); Bonnabel, Antoine, 59000 Lille (FR); Segueni, Karim, 59170 Croix (FR)
(74) Representative: Grünecker Patent- und Rechtsanwälte PartG mbB

(57) **Abstract**

The present invention relates to a method of manufacturing an MEMS device that comprises the steps of forming a first membrane layer over a sacrificial base layer, forming a second membrane layer over the first membrane layer, wherein the second membrane layer comprises lateral recesses exposing lateral portions of the first membrane layer and forming stoppers to restrict movement of the first membrane layer. Moreover, it is provided MEMS device comprising a movable membrane comprising a first membrane layer and a second membrane layer formed over the first membrane layer, wherein the second membrane layer comprises lateral recesses exposing lateral portions of the first membrane layer.

## Description

### Field of Invention

The present invention relates to Micro-Electromechanical Systems (MEMS), particularly, to RF MEMS switches and capacitors comprising thick membranes.

### Background of the invention

Micro Electromechanical Systems (MEMS) are used in a very broad diversity of applications, as sensors, actuators or passive devices. RF MEMS in particular are used in radio frequency applications such as radio transmission, and in various industries such as mobile telecommunications. In mobile phones for example, RF MEMS can be used in the RF front-end for antenna tuning or antenna switching. MEMS components offer for those applications strong technical advantages such as very low insertion losses, high isolation in the case of switches, and very high linearity (over 70 dB in IIP3) compared to other technologies such as solid state devices.

More specifically regarding RF MEMS switches, the actuation principle remains the same in all existing art: a conducting transmission line is either opened or closed by the means of an electromechanical actuation. The closing of the transmission line can be made for example using a conducting element featured on a beam, a bridge or a membrane located at short distance from two conductive ends of the transmission line separated one from the other in order to avoid electric conduction in the transmission line. The beam, the bridge or the membrane can be then electromechanically actuated so that the featured conductive element shorts the circuit between the two conductive ends of the transmission line through Ohmic contact for example, thus creating a conductive line and therefore closing the switch.

As mentioned before, the part supporting the conductive element can be either a beam (anchored at one end), a bridge (anchored on two ends) or a membrane (either free or featuring several anchors). According to an embodiment, the membrane can be completely free and maintained by pillars and stoppers (cf. EP 1 705 676 A1 and EP 2 230 679 A1).

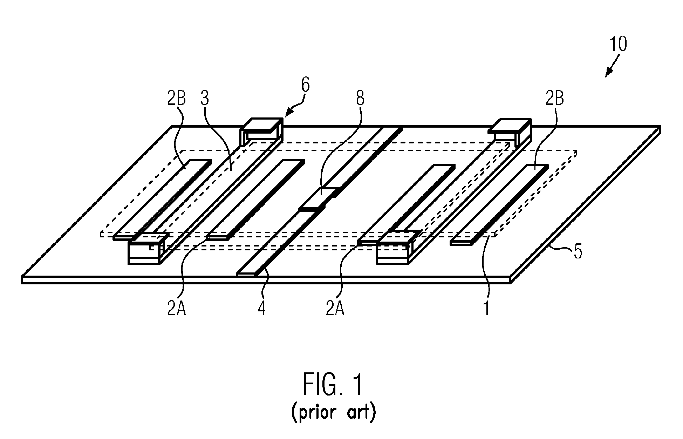

An example of a known MEMS switch structure comprising a freely supported membrane is illustrated in Figure 1. In order to bend the freely supported membrane 1, the MEMS structure 10 comprises electric actuation means that are adapted to bend the flexible membrane in order to lower the functional part of the membrane. The functional part of the membrane is a conductive element 8 featured under the part of the membrane in-between the two posts and that shorts the transmission line in closed mode. The electric lowering actuation means are typically constituted by external actuation electrodes 2A located under the membrane 1 that are adapted to exert electrostatic pulling forces directly to the membrane 1 in-between the posts when an actuation voltage is applied on the electrodes 2A. Theses pulling forces combined with a lever effect on the posts 3 enable to bend the membrane 1. By the bent membrane Ohmic contact to a transmission line 4 is realized thanks to the contact featured under the membrane. The transmission line 4 may be adapted to transmit an RF signal. In the shown example the electrodes 2, posts 3 and the transmission line 4 are formed on the same substrate 5. In order to come back to the rest position or to go in isolation position (a position where the gap between the conductive element and the conductive plots is maximal), actuation voltage of electrodes 2A goes back to 0 and actuation voltage is applied to external electrodes 2B which will perform a lever effect with the posts 3 thus bending the membrane the other way. It is noted that the freely supported membrane switch can also function as a capacitive contact switch rather than an Ohmic contact one.

As can be seen from Figure 1, stoppers 6 have to be provided in order to restrict the movement of the free membrane 1 in all three directions. In typical applications movement of the membrane has to be restricted to some µm in order to guarantee reliable and repeatable operations of the switch structure.

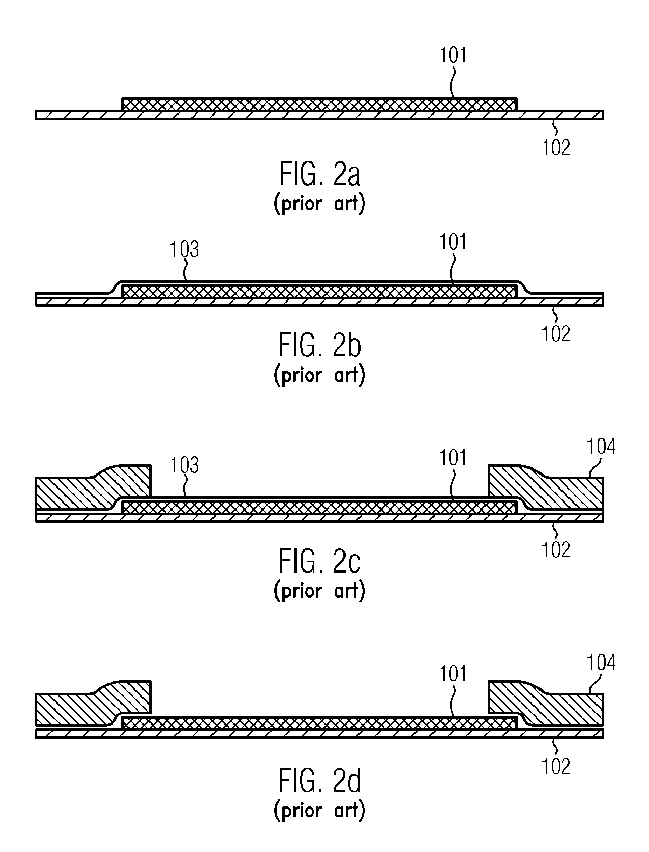

The conventional method of manufacturing the switch structure shown in Figure 1 comprises the formation of the membrane layer 101 on a sacrificial base layer 102 (see Figure 2a) which is removed at a finishing state of the manufacturing process. Next, a sacrificial layer 103 is formed on the membrane layer 101 and the parts of the sacrificial base layer 102 that are not covered by the membrane layer 101 (see Figure 2b). A stopper layer is formed on the sacrificial layer 103 and etched in order to form stoppers 104 as shown in Figure 2c. After formation of the stoppers 104 the sacrificial layer 103 is removed (Figure 2d). Thereafter or simultaneously sacrificial base layer 102 is removed and the membrane layer 101 can fall on posts 3 shown in Figure 1.

However, reliable operation of an MEMS device, for example, an MEMS switch with freely supported membrane 1 demands for a thickness of the membrane 1 in the central part (for mechanical reasons) in the presented art of at least 3 µm. It turned out that in conventional processing as shown in Figures 2a to 2d, the necessary thickness for the sacrificial layer 103 for reliable coverage of the membrane layer 101 results in a lateral spacing between each of the stoppers 104 and the corresponding edges of the membrane 1 of about 1.5 µm resulting in a lateral free moving space of the membrane 1 of about 3 µm. Such a relative large lateral free moving space of the freely supported membrane 1 can adversely affect reliable operation of the MEMS switch. A similar reasoning holds for the operation of a variable capacitor comprising a membrane electrode that is moveable for adjustment of the capacitance.

Thus, there is a need for an improved MEMS device and a method of manufacturing of the same wherein the reliability of operation is enhanced as compared to the art.

### Description of the Invention

The above-mentioned object is addressed by a method of manufacturing an MEMS device according to claim 1. The method comprises the steps of forming a first membrane layer over (for example, on) a sacrificial base layer, forming a second membrane layer over (for example, on) the first membrane layer), wherein the second membrane layer comprises lateral recesses that expose lateral portions of the first membrane layer and forming stoppers to restrict movement of the first membrane layer when operating the MEMS device. The lateral portions of the first membrane layer exposed by the second membrane layer may be covered by any other material layer, in principle. According to the invention, a membrane is provided as a moving element of an MEMS device that comprises a first membrane layer covered by a second membrane layer except at some lateral regions where recesses are formed in the second membrane layer. The recesses may be arranged in the longitudinal direction of the membrane at edges of the second membrane layer (see also detailed description below). Herein, the term "longitudinal" refers to the longitudinal axis of the membrane whereas the term "transverse" refers to the transverse axis of the same.

Movement of the membrane comprising the first and second membrane layers is restricted by mechanical contact of the first membrane layer with the stoppers. In operation, the first membrane layer may contact the stoppers that partly may extend into the recesses of the second membrane layer without contacting the second membrane layer when in contact with the first membrane layer. The free moving distance of the membrane is given by the gap between the stoppers and the edges of the first membrane layer. Since the first membrane layer is thinner than a conventionally used membrane of uniform thickness the free moving distance of the membrane can be reduced as compared to the art as a sacrificial layer with a thinner thickness has to be applied over the membrane during the manufacturing process, thereby improving reliability of operation.

In particular, the second membrane layer may be formed thicker than the first membrane layer. The first membrane layer may be formed at a thickness of at most 2 µm, particularly, at most 1 µm, and the second membrane layer may be formed at a thickness of at least 2 µm.

According to an embodiment, a sacrificial layer (for example, made of a polymeric or other dielectric material) is formed over (for example, on) the first membrane layer and over parts of the sacrificial base layer that are not covered by the first membrane layer and the forming of the stoppers comprises forming a stopper layer over the sacrificial layer and patterning, for example, by etching, the stopper layer to form the stoppers provided for restricting movement of the first membrane layer. The thickness of the first membrane layer determines the thickness of the sacrificial layer (see detailed description below) and thereby the free moving distance of the membrane comprising the first and second membrane layers during operation of the MEMS device.

Furthermore, the inventive method may comprise removing, for example, etching, the sacrificial layer over a portion of the first membrane layer and forming the second membrane layer over the portion of the first membrane layer that is exposed by the process of removing the sacrificial layer. In this embodiment, the above-mentioned recesses of the second membrane layer are formed by not completely covering the first membrane layer by the second membrane layer due to the parts of the sacrificial layer that are not removed before the formation of the second membrane layer.

The stoppers and the second membrane layer can be formed in the same processing step thereby accelerating and simplifying the overall processing. Moreover, the stopper layer and the second membrane layer can be formed of the same material, for example, a metal or electrically conductive alloy. According to an alternative embodiment, the stopper layer as well as the stoppers are formed before removing the sacrificial layer over (for example, on) the portion of the first membrane layer.

The MEMS device may comprise electrodes as actuation means that are formed over a substrate. The substrate can be a wafer of silicon, silicon-on-insulator, silicon-on-sapphire, gallium-arsenide, gallium-nitride, glass, quartz, aluminum or any other material used for the manufacturing of semiconductor devices. The substrate can, furthermore, be covered by a thin layer of insulating material, for example made of silicon nitride, silicon dioxide, aluminum oxide or any other dielectric layer used for the manufacturing of microelectronics devices. Additionally, functional layer of materials and functional structures may be featured on said wafer, such as electrical connections, protective bumps or support pillars prior to the manufacturing of the membrane layers.

The stoppers may be formed in mechanical contact with the substrate and the method may further comprise forming posts and a transmission line (e.g., made of aluminum or gold) over the substrate and it may comprise removing the sacrificial base layer that may be formed on or over the posts and arranging the first membrane layer (and thereby the second membrane layer formed over the first one) on the posts allowing free movement of the membrane comprising the first and second membrane layers.

The steps of the above-mentioned examples of the method of manufacturing an MEMS device may be carried out in order to achieve a capacitive or Ohmic contact MEMS switch. Alternatively, the steps of the above-mentioned examples of the method of manufacturing an MEMS device may be carried out in order to achieve an MEMS capacitor. In the case of an MEMS capacitor the membrane may represent one of the electrodes of the capacitor.

According to an embodiment the method may further comprise forming a third membrane layer over (for example, on) the second membrane layer locally in a region over the posts whereon the membrane rests and/or a region over the transmission line. The third membrane layer may be formed over the first membrane layer in a region over one of the posts (in particular, over all posts) and/or a region over the transmission line such that the third membrane layer only partially overlaps the second membrane layer. The third membrane layer may be formed over the first membrane layer in a region over one of the posts (in particular, over all posts) and/or a region over the transmission line such that the second membrane layer has a region where the third membrane layer is not formed adjacent to the region where the third membrane layer is formed. The third membrane layer may overlap the posts and/or transmission line (conduction line) in the width directions of the same by some amount, for example, the overlap may be below 2 widths or 1 widths of the posts/transmission line. The third membrane layer may be formed in a region extending along the entire length of a post (in the transverse direction) or only partly along the post and may cover the post completely or partly and have a width in the range of ¼ to 2 times the width of the post. The third membrane layer may be formed in a region extending along the entire length of a transmission line (in the transverse direction) or only partly along the transmission line and may cover the transmission line completely or partly and have a width in the range of ¼ to 2 times the width of the transmission line or larger. The third membrane layer allows for enhancing reliability of the switching process and may improve the switching speed. In particular, the third membrane layer locally stiffening the membrane may be provided in order to increase contact forces and reduce insertion losses.

In addition, the method may further comprise forming an overhanging portion of the second membrane layer extending over a recess of the lateral recesses of the second membrane layer. By provision of the overhanging portion the first membrane layer can be protected during the process of patterning a material layer for forming the second membrane layer (and the stoppers); see detailed description below. The second membrane layer may comprise overhanging portions extending over all of the recesses, for example. Furthermore, the above-mentioned object is addressed by an MEMS device (in particular, either a capacitive or Ohmic contact switch or an MEMS capacitor) that comprises a movable membrane comprising a first membrane layer and a second membrane layer formed over (for example, on) the first membrane layer (101), wherein the second membrane layer comprises lateral recesses exposing lateral portions of the first membrane layer. The lateral portions of the first membrane layer exposed by the second membrane layer may be covered by any other material layer, in principle. In operation stoppers may mechanically contact the membrane at edges of the first membrane layer that may have a larger or smaller overall surface area than the second membrane layer. The mechanical contact can be localized within the recesses of the second membrane layer, i.e., the stoppers may partly extend into the recesses without contacting the second membrane layer when contacting the first membrane layer.

In particular, the second membrane layer may be thicker than the first membrane layer. In this case, the first membrane layer can be formed at a thickness of at most 2 µm, particularly, at most 1 µm, and the second membrane layer can be formed at a thickness of at least 2 µm.

According to an embodiment, the MEMS device further comprises posts for supporting the first membrane layer. The first membrane layer is moveable on the posts (together with the second membrane layer formed over the first membrane layer). Stoppers may be configured to contact edges of the first membrane layer within the recesses of the second membrane layer, i.e., the stoppers have parts that extend into the recesses of the second membrane layer when other parts of the stoppers contact the first membrane layer.

The above-described MEMS device may further comprise a substrate, electrodes (for example, made of some refractory metal) and a transmission line and wherein the electrodes, transmission line and the above-mentioned posts are formed over the substrate. As described above the substrate maybe a wafer of silicon, silicon-on-insulator, silicon-on-sapphire, gallium-arsenide, gallium-nitride, glass, quartz, aluminum or any other material used for the manufacturing of semiconductor devices.

The MEMS device may further comprise a third membrane layer formed over the second membrane layer locally in a region over the posts whereon the membrane rests and/or a region over the transmission line. The third membrane layer may be formed over the second membrane layer in a region over one of the posts (in particular, over all posts) and/or a region over the transmission line such that the third membrane layer only partially overlaps the second membrane layer. The third membrane layer may be formed over the second membrane layer in a region over one of the posts (in particular, over all posts) and/or a region over the transmission line such that the second membrane layer has a region where the third membrane layer is not formed adjacent to the region where the third membrane layer is formed. The third membrane layer may overlap the posts and/or transmission line in the width directions of the same by some amount, for example, the overlap may be below 2 widths or 1 widths of the posts/transmission line. The third membrane layer may be formed in a region extending along the entire (transverse) length of a post or only partly along the post and may cover the post completely or partly and have a width in the range of ¼ to 2 times the width of the post. The third membrane layer may be formed in a region extending along the entire (transverse) length of a transmission line or only partly along the transmission and may cover the transmission line completely or partly and have a width in the range of ¼ to 2 times the width of the transmission line or larger The second membrane layer may comprise an overhanging portion over a recess of the lateral recesses of the second membrane layer. The second membrane layer may comprises overhanging portions extending over all of the recesses.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figure 1 illustrates an MEMS switch of the art.
Figures 2a to 2d illustrate steps of the manufacturing of an MEMS switch according to the art.
Figures 3a to 3e illustrate a method of manufacturing of an MEMS switch comprising a two-layer flexible membrane according to an example of the present invention.
Figures 4a to 4c illustrate a method of manufacturing of an MEMS switch comprising the formation of stoppers and a second layer of a two-layer flexible membrane according to an example of the present invention.
Figures 5a to 5c illustrate a method of manufacturing of an MEMS switch comprising the formation of stoppers and a second layer of a two-layer membrane comprising overhanging portions according to another example of the present invention.
Figures 6a to 6c illustrate a method of manufacturing of an MEMS switch comprising the formation of stoppers and a three-layer membrane according to an example of the present invention.
Figure 7 shows a top view of the configurations shown in Figure 3e, 4c and 5c.
Figure 8 shows a top view of the configuration shown in Figure 6c.

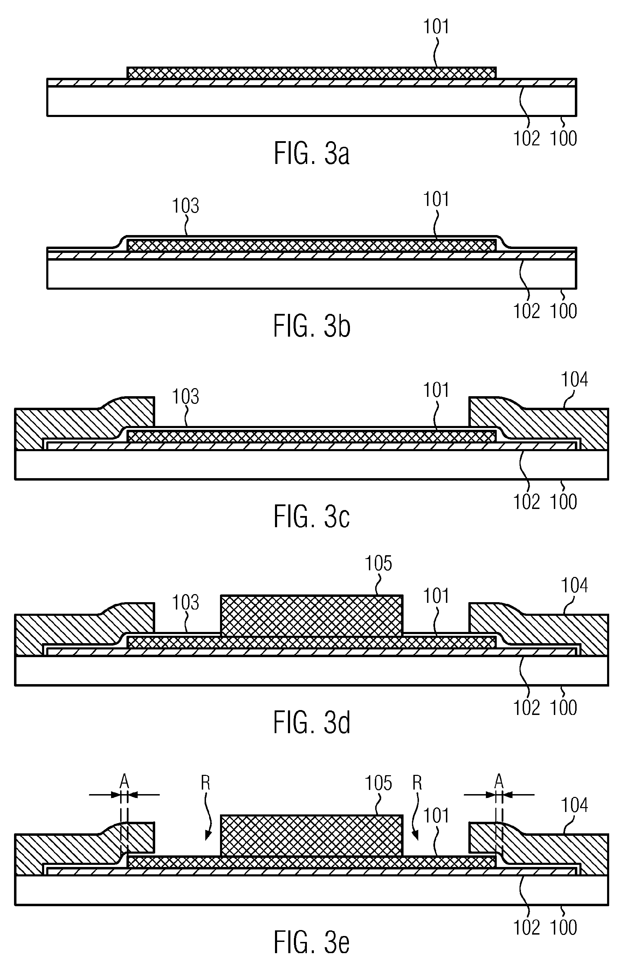

A method of manufacturing of an MEMS switch comprising a two-layer movable membrane according to an example of the present invention is described with reference to Figures 3a to 8. The MEMS device comprises a movable element in form of a two-layered membrane that, for example, may be formed of a conductive alloy or metal. The MEMS device, in principle, can be a capacitive or Ohmic contact MEMS switch or a capacitor.

As shown in Figure 3a a first membrane layer 101 is formed over a sacrificial base layer 102. The sacrificial base layer 102 is formed over layer 100. In the following, for exemplary purposes, it is assumed that layer 100 represents a post (confer Figure 1) formed on a substrate. The finally produced membrane will rest on the post (see description below). A sacrificial layer 103 is formed over the first membrane layer 101 and the sacrificial base layer 102 over portions not covered by the first membrane layer 101 (see Figure 3b). The sacrificial layer 103 may be formed, for example, by spin-coating, of a polymeric or dielectric material.

A stopper layer is formed over the sacrificial layer 103 and etched in order to form stoppers 104 that are connected to layer 100 (see Figure 3c). Next, the sacrificial layer 103 is etched over a major portion of the first membrane layer 101. After the etching process the sacrificial layer 103 is only maintained over relatively small lateral regions of the first membrane layer 101. Over the exposed major portion of the first membrane layer 101, a second membrane layer 105 is formed (see Figure 3d). It is noted that the second membrane layer 105 is not necessarily exactly centered on the first membrane layer 101. The surface area of the first membrane layer 101 is may be larger or smaller than the one of the second membrane layer 105 formed thereon. The second membrane layer 105 may be formed of the same material as the first membrane layer 101, for example, of an electrically conductive alloy or metal material (comprising aluminium or gold for example). Both the first membrane layer 10 and the second membrane layer 105 may comprise sublayers. Both the stopper layer and the second membrane layer 105 may be formed by deposition.

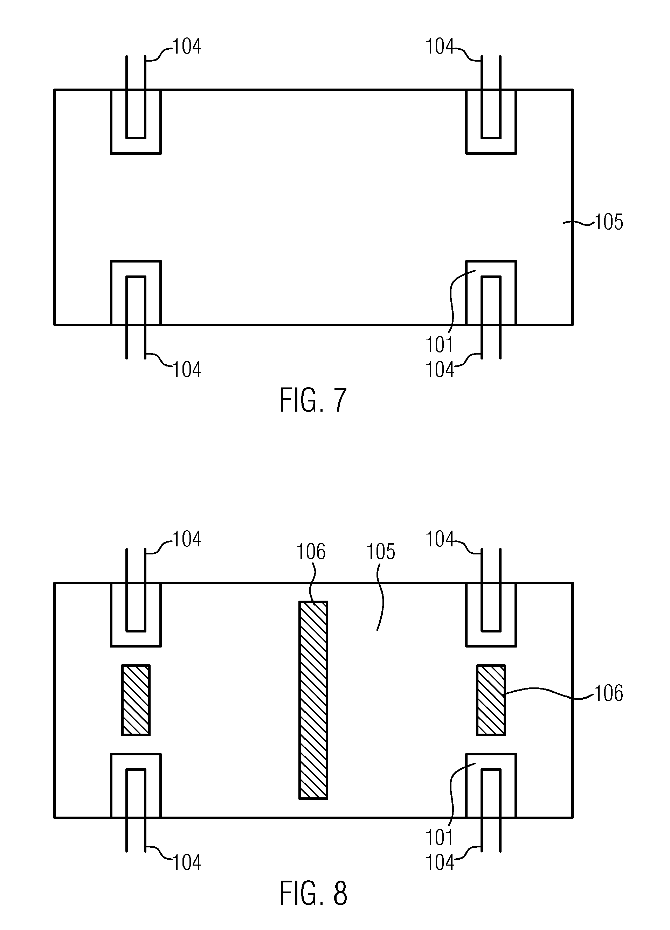

As it is illustrated in Figure 3e the sacrificial layer 105 is removed, for example, by reactive ion etching or plasma etching. The resulting second membrane layer 105 shows lateral recesses R arranged over lateral portions of the first membrane layer 101 where the sacrificial layer 103 is removed. Moreover, the sacrificial base layer 102 is removed. The sacrificial layer 103 and the sacrificial base layer 102 may be removed during one etching process, for example, or they may be removed one after the other. After removal of the sacrificial base layer 102 the freely moveable membrane comprising the first and second membrane layers 101 and 105 falls on layer 100 (not shown in Figure 3e). The stoppers 104 are arranged to contact edges of the first membrane layer 101 within the recesses of the second membrane layer 105 without contacting the second membrane layer 105 (confer also Figure 7 showing a top view of the configuration comprising the first and second membrane layers 101 and 105 and stoppers 104 that are partly arranged within the recesses of the second membrane layer 105). When contacting the first membrane layer 101 with some part a stopper does not contact the second membrane layer 105 with a part extending into a recess R of the second membrane layer 105. The resulting lateral free moving space (distance) depends on the thickness of the sacrificial layer. In total, the lateral free moving distance adds up to 2A (see Figure 3e). According to a particular example, 2A does not exceed about 1 µm. For example, the first membrane layer 101 has a thickness of about 1 µm, the thickness of the second membrane layer 105 is about 2 µm or more and the thickness of the sacrificial layer 103 is about 0.5 µm.

Contrary to the art, according to the present invention the membrane comprises a thicker portion and thinner portions at the recesses R of the second membrane layer 105. The thinner portions allow for a thinner sacrificial layer resulting in a smaller lateral free moving space (distance) of the movable (freely supported) membrane as compared to the art. The smaller lateral free moving space allows for a more reliable operation of the resulting MEMS switch.

In the example shown in Figures 3a to 3e the second membrane layer 105 is formed subsequently to the formation of the stoppers 104. However, the configuration shown in Figure 3e can be formed in different ways. In particular, the second membrane layer 105 and the stoppers 104 can be formed simultaneously. The thicknesses of these layers may be the same or may differ from each other.

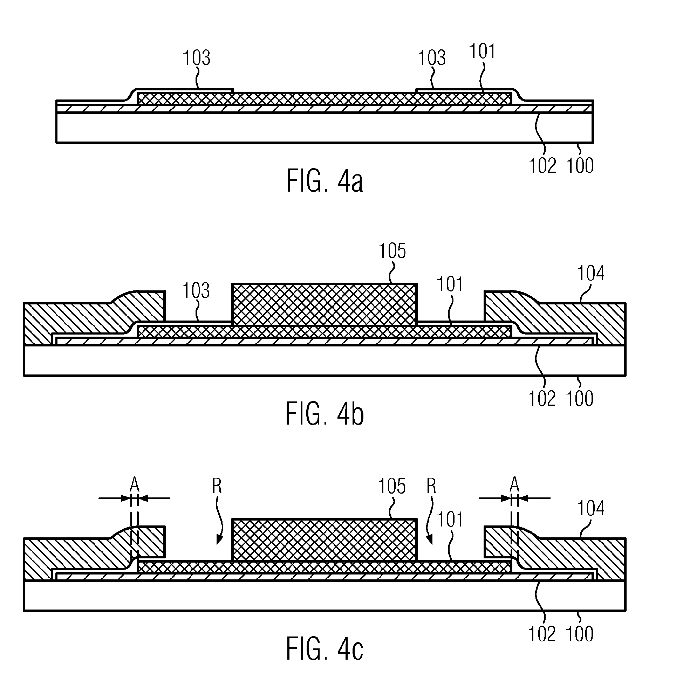

According to the example shown in Figure 4a the configuration shown in Figure 3b is etched to remove the sacrificial layer 103 over a major portion of the first membrane layer 101 before the formation of the stoppers 104. The sacrificial layer 103 is maintained on distinct lateral regions of the first membrane layer 101. Again, the sacrificial layer 103 may be formed of a polymeric or dielectric material and may be etched by reactive ion etching, for example. A second membrane layer 105 is formed over the first membrane layer 101 in the etched region. Moreover, a stopper layer is formed over the sacrificial layer 103 and etched in order to form stoppers 104 connected to layer 100 (see Figure 4b). For example, the stoppers 104 and the second membrane layer 105 may be formed of the same material that may be a metal material or an electrically conductive alloy. For example, the stoppers 104 and the second membrane layer 105 may be formed in the same processing step. The processing step may comprise some deposition techniques as known in the art. The deposition techniques may involve deposition of an electroplating seed layer followed by electroplating of a material layer that subsequently is patterned to form the second membrane layer 105 and stopper 104, for example.

After formation of the stoppers 104 and second membrane layer 105 the sacrificial layer 103 is removed (Figure 4c). Moreover, sacrificial base layer 102 is removed such that the membrane comprising the first and second membrane layers 101 and 105 can fall on layer (post) 100. Similar to the example shown in Figure 3e a smaller lateral free moving space (distance) 2A of the movable (freely supported) membrane as compared to the art results.

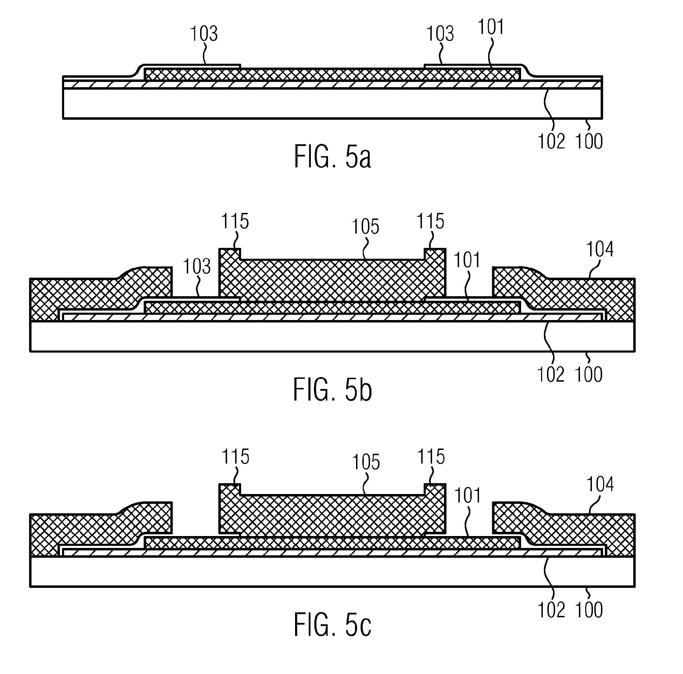

A modified version of the example illustrated in Figures 4a to 4c is shown in Figures 5a to 5c. Different from the example shown in Figures 4a to 4c the second membrane layer 105 comprises overhanging portions 115 extending in the direction of the recesses of the second membrane layer 105. In order to arrive at the structures shown in Figure 4b a material layer may be continuously formed over the structure shown in Figure 4a, covered by a patterned mask and etched in order to achieve the stoppers 104 and second membrane layer 105.

However, the material layer has to be over-etched to some degree above the sacrificial layer 103 in order to guarantee that the sacrificial layer 103 can be properly removed in the further proceedings. Due to some mismatch between the second membrane layer 105 and the sacrificial layer 103 there is a risk that the underlying first membrane layer 101 can be attacked (at the lower edges of the second membrane layer 105) during the etching of the material layer. This risk can be avoided by the formation of the overhanging regions 115 over the sacrificial layer 103 as it is shown in Figures 5b and 5c.

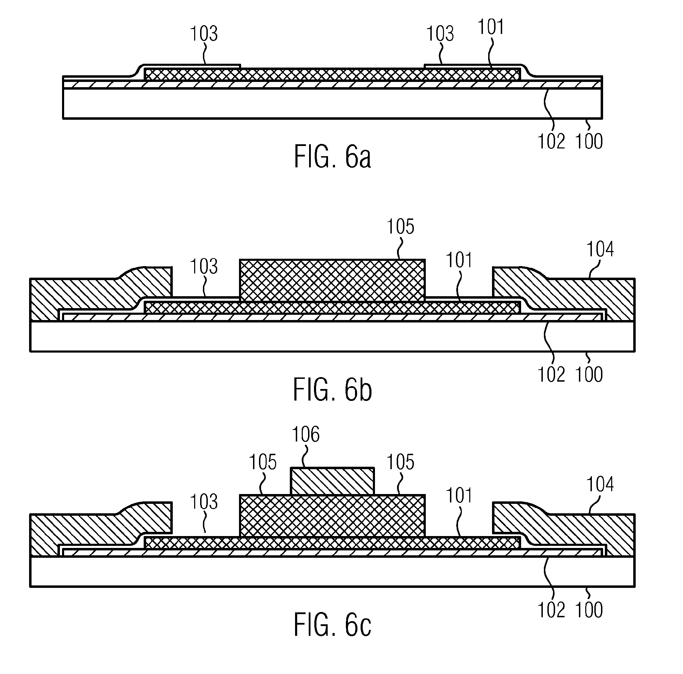

A further modified version of the example illustrated in Figures 4a to 4c is shown in Figures 6a to 6c. The manufacturing of this modified example is similar to the one described with reference to Figures 4a to 4c with the exception of an additional third membrane layer 106 that is formed on the second membrane layer 105. The third membrane layer 106 may be formed over posts and/or a transmission (conduction) line (confer Figures 1 and 8). The third membrane layer 106 when provided over a transmission (conduction) line can give rise to an enhancement of the contact force thereby resulting in an improved reliability of the switching process. When formed over posts whereon the freely moving membrane rests the third membrane layer 106 improves the force transfer on the posts thereby allowing for an acceleration of the switching process.

A top view of the configurations shown in Figures 3e, 4c and 5c is shown in Figure 7. As can be seen in Figure 7 the second membrane layer 105 comprises lateral recesses arranged along the longitudinal direction (from left to right) exposing parts of the first membrane layer 101. During operation the movement of the membrane comprising the first and second membrane layers 101 and 105 is restricted by the stoppers 10 partly provided within the recesses of the second membrane.

A top view of the configuration shown in Figure 6c is shown in Figure 8. A third membrane layer 106 is formed over regions of the second membrane layer 105 over posts whereon the membrane rests and a conduction line contacted by a conductive part featured under the membrane during a switching process. The third membrane layer may completely or partially overlap the posts and/or transmission line formed below the membrane in the longitudinal and/or transverse direction. The posts and the conduction line extend in the transverse direction (up-down). Recesses of the second membrane layer are arranged along the longitudinal direction (from left to right).

In both configurations shown in Figures 7 and 8 the overall surface area of the second membrane layer may be larger or smaller than the one of the first membrane layer. The first membrane layer may be shaped such that it does not extend over the entire regions of the recesses. Moreover, the shape of the membrane comprising the first and second membrane layers may be varied. For example, additional recesses in both the first and second membrane layers may be provided in the longitudinal direction. In particular, both the first and second membrane layers may comprises lateral recesses at a longitudinal position where the transmission line is located on the substrate of the MEMS device. It should be noted that configurations comprising the first and the second membrane layers 101 and 105 and comprising an additional third membrane layer 106 and comprising overhanging portions of the second membrane layer 105 can be freely combined with each other.

The configurations shown in Figures 3e, 4c, 5c, 6c, 7 and 8 can be implemented in the MEMS switch shown in Figure 1 in order to obtain an MEMS switch with improved reliability of operation.

Whereas according to the above-described examples an MEMS switch is formed, the same manufacturing steps can be used in the process of forming an MEMS capacitor. In this case, the membrane comprising the first and second membrane layers 101 and 105 can function as an electrode in a configuration similar to the one shown in Figure 1. Moreover, in a configuration similar to the one shown in Figure 1 the other electrode of the MEMS capacitor can be formed at the position of the transmission line 4 (the transmission line 4 of the switch illustrated in Figure 1 functions as an electrode of the capacitor). By means of the actuation electrodes 2 the distance between the electrodes of the MEMS capacitor can be varied thereby tuning the capacitance. Consequently, a variable MEMS capacitor with a movable membrane representing an electrode of the capacitor and stoppers is obtained.

All previously discussed embodiments are not intended as limitations but serve as examples illustrating features and advantages of the invention. It is to be understood that some or all of the above described features can also be combined in different ways.

## Claims

1. A method of manufacturing an MEMS device, in particular, a capacitive switch or an Ohmic contact switch or an MEMS capacitor, comprising the steps of:
forming a first membrane layer (101) over a sacrificial base layer (102);
forming a second membrane layer (105) over the first membrane layer (101),
wherein the second membrane layer (105) comprises lateral recesses (R) exposing lateral portions of the first membrane layer (101); and
forming stoppers (104) to restrict movement of the first membrane layer (101).

2. Method according to claim 1, wherein the stoppers are arranged to contact edges of the first membrane layer (101) in the recesses (R) of the second membrane layer (105) during operation of the MEMS device.

3. Method according to one of the preceding claims, wherein the second membrane layer (105) is formed thicker than the first membrane layer (101).

4. Method according to one of the preceding claims, further comprising forming a sacrificial layer (103) over the first membrane layer (101) and over parts of the sacrificial base layer (102) not covered by the first membrane layer (101) and wherein the forming of the stoppers (104) comprises forming a stopper layer over the sacrificial layer (103) and patterning the stopper layer to form the stoppers (104).

5. Method according to claim 4, further comprising removing the sacrificial layer (103) from a portion of the first membrane layer (101) and wherein the second membrane layer (105) is formed over the portion of the first membrane layer (101) exposed by the removing process.

6. Method according to claim 5, wherein the stopper layer and the second membrane layer (105) are formed in the same processing step and/or of the same material.

7. Method according to claim 5, wherein the stopper layer and the stoppers are formed before removing the sacrificial layer (103) over the portion of the first membrane layer (101).

8. Method according to one of the preceding claims, wherein the stoppers (104) are formed in mechanical contact with a substrate and further comprising forming posts, electrodes and a transmission line over the substrate and removing the sacrificial base layer (102) and arranging the first and second membrane layers (101, 105) on the posts.

9. Method according to claim 8, further comprising forming a third membrane layer (106) over the second membrane layer (105) in a region over one of the posts and/or a region over the transmission line such that the third membrane layer (106) only partially overlaps the second membrane layer (105).

10. Method according to one of the preceding claims, further comprising forming an overhanging portion (115) of the second membrane layer (105) over a recess of the lateral recesses of the second membrane layer (105).

11. MEMS device, in particular, a capacitive switch or an Ohmic contact switch or an MEMS capacitor, comprising
a movable membrane comprising a first membrane layer (101) and a second membrane layer (105) formed over the first membrane layer (101), wherein the second membrane layer comprises lateral recesses (R) exposing lateral portions of the first membrane layer (101) .

12. MEMS device according to claim 11, further comprising posts for supporting the first membrane layer (101) that is moveable on the posts and stoppers (104) configured to contact edges of the first membrane layer (101) in the recesses (R) of the second membrane layer (105).

13. MEMS device according to claim 12, further comprising a substrate, electrodes and a transmission line and wherein the electrodes, transmission line and posts are formed over the substrate.

14. MEMS device according to claim 13, further comprising a third membrane layer (106) over the second membrane layer (105) in a region over one of the posts and/or a region over the transmission line such that the third membrane layer (106) only partially overlaps the second membrane layer (105).

15. MEMS device according to one of the claims 11 to 14, wherein the second membrane layer (105) comprises an overhanging portion (115) of the second membrane layer (105) over a recess (R) of the lateral recesses (R) of the second membrane layer (105).
